# EUROPÄISCHE PATENTSCHRIFT

(11) **EP 1 467 608 B1**
(45) Veröffentlichungstag und Bekanntmachung des Hinweises auf die Patenterteilung: **19.06.2019**
(21) Anmeldenummer: 04004162.6
(22) Anmeldetag: 25.02.2004
(51) Int. Cl.: H05K 9/00

(54) **Abschirmung für ein Hochfrquenzgerät, insbesondere einen TV-Tuner eines Fahrzeuges**
High frequency device shield particularly for vehicle TV-tuner
Blindage pour un appareil hautes fréquences, d'un syntonisateur TV d'une automobile en particulier

(30) Priorität: 11.04.2003 DE 10317000
(43) Veröffentlichungstag der Anmeldung: 13.10.2004
(73) Patentinhaber: Hirschmann Car Communication GmbH, 72654 Neckartenzlingen (DE)
(72) Erfinder: Silva, David, 72654 Neckartenzlingen (DE)
(74) Vertreter: Greif, Thomas

(56) Entgegenhaltungen:
- WO-A-00/27178
- DE-A1- 3 922 461
- US-A- 4 337 444
- US-A- 5 159 537
- US-A- 5 231 561
- US-A- 5 907 478
- US-A- 6 118 347
- US-B1- 6 288 903

## Beschreibung

Die Erfindung betrifft eine Abschirmung für eine elektronische Schaltung eines Hochfrequenzgerätes, insbesondere eines TV-Tuners, eines Fahrzeuges gemäß den Merkmalen des Oberbegriffs des Patentanspruchs 1.

Hochfrequenzgeräte, wie beispielsweise Antennenverstärker oder TV-Tuner oder dergleichen, in Fahrzeugen sind bekannt. Bei diesen Hochfrequenzgeräten sind eine oder meistens auch mehrere elektronische Schaltungen, bei denen elektronische Bauteile auf Leiterplatten angeordnet sind, in einem Gehäuse des Hochfrequenzgerätes zusammengefaßt. Aufgrund der Frequenzen, die einige hundert Megahertz betragen und bis in den Gigahertzbereich reichen können, mit denen diese Hochfrequenzgeräte betrieben werden, kommt es zu Abstrahlungen von den elektronischen Schaltungen, die bei anderen Geräten zu Störungen führen können. Außerdem besteht die Gefahr, daß externe Störquellen in die elektronischen Schaltungen des Hochfrequenzgerätes einstrahlen, so daß es hierbei ebenfalls zu Störungen, bis hin zum Ausfall, kommen kann. Daher ist es schon grundsätzlich bekannt, die elektronische Schaltung mit einem Abschirmblech zu versehen. Ein solches zusätzliches Abschirmblech bedeutet aber immer einen weiteren Montageaufwand, da dieses auf geeignete Art und Weise zu seiner Funktionserfüllung in dem Hochfrequenzgerät befestigt werden muß. Darüber hinaus ist es schon bekannt, das Gehäuse aus einem Material aus Metall herzustellen, um somit die Abschirmung zu gewährleisten. Hier hat es sich allerdings herausgestellt, daß die Abschirmung der elektronischen Schaltung nur mittels des Gehäuses aus Metall nicht ausreichend ist.

Abschirmung für eine elektronische Schaltung eines Hochfrequenzgerätes ist zum Beispiel aus Dokumenten US5907478 und US4337444 bekannt.

Der Erfindung liegt daher die Aufgabe zugrunde, eine Abschirmung für eine elektronische Schaltung eines Hochfrequenzgerätes bereitzustellen, mit der die eingangs geschilderten Nachteile vermieden werden.

Diese Aufgabe ist durch die Merkmale des Patentanspruchs 1 gelöst.

Erfindungsgemäß ist vorgesehen, daß das Abschirmblech zumindest planparallel zu der elektronischen Schaltung angeordnet ist, wobei die Befestigung der elektronischen Schaltung in dem Hochfrequenzgerät über das Abschirmblech erfolgt. Dabei ist das Abschirmblech derart ausgestaltet, daß es einerseits an einem Teil des Hochfrequenzgerätes, insbesondere einer Bodenplatte des Gehäuses des Hochfrequenzgerätes, befestigt werden kann, und gleichzeitig die Befestigung der elektronischen Schaltung übernimmt. Dadurch kann die elektronische Schaltung auf einfache Art und Weise in dem Hochfrequenzgerät befestigt werden, wobei gleichzeitig auch die Abschirmung erfolgt. Weitere oder sonstige Befestigungsmittel für die elektronische Schaltung in dem Hochfrequenzgerät sind daher nicht erforderlich.

In einer Ausgestaltung der Erfindung weist das Abschirmblech einerseits Füße zur Befestigung in dem Hochfrequenzgerät und andererseits Klemmittel zur Halterung elektrischen Schaltung auf. Über die Füße kann das Abschirmblech an einem Teil des Hochfrequenzgerätes, insbesondere der Bodenplatte, befestigt werden, wobei anschließend oder vorher die elektronische Schaltung über Klemmittel an dem Abschirmblech befestigt wurde. Die Klemmittel haben einerseits den Vorteil, daß sie die elektronische Schaltung zuverlässig an dem Abschirmblech festhalten, was gerade bei Anwendungen solcher Hochfrequenzgeräte in Fahrzeugen aufgrund der dort herrschenden Vibrationen von großer Wichtigkeit ist. Andererseits kann gleichzeitig durch die Klemmwirkung ein Toleranzausgleich erfolgen, so daß die beteiligten Elemente, wie Leiterplatte der elektronischen Schaltung und Abschirmblech mit niedriger oder normaler ausreichender Toleranz gefertigt werden können. Durch die Klemmittel wird auch ein Spielausgleich gewährleistet, wenn die Leiterplatte der elektronischen Schaltung mit ihrer Unterkante bündig auf der Bodenplatte des Hochfrequenzgerätes aufliegt, so daß Größenveränderungen der Leiterplatte aufgrund von Temperaturänderungen ausgeglichen werden können. Die Füße bewirken auf der anderen Seite, daß die Unterkante des Abschirmbleches nicht vollständig, z. B. auf der Bodenplatte des Hochfrequenzgerätes aufliegt, sondern daß ein Schlitz, ein Fenster oder dergleichen gebildet ist, durch welches Kühlluft strömen kann, um die elektronische Schaltung im Betrieb des Hochfrequenzgerätes zu kühlen. In einer weiteren Ausgestaltung der Erfindung ist das Abschirmblech derart ausgebildet, daß es die elektronische Schaltung nahezu vollständig umgibt. Damit ist sichergestellt, daß die elektronische Schaltung vor von außen auf sie einwirkende Strahlungen geschützt ist. Außerdem wird vermieden, daß die ebenfalls mit sehr hohen Frequenzen arbeitende elektronische Schaltung ihrerseits Störstrahlungen abgibt. Das ist vor allen Dingen dann wichtig, wenn in einer weiteren Ausgestaltung der Erfindung in dem Hochfrequenzgerät mehrere elektronische Schaltungen in etwa planparallel angeordnet sind. Für diesen Fall weist jede elektronische Schaltung ein eigenes Abschirmblech auf, so daß die Einwirkung von Störstrahlungen untereinander wirksam vermieden wird. Dabei sind alle elektronischen Schaltungen (Module) mit einem Abschirmblech versehen, was sie nahezu vollständig umgibt, wobei die sich am Anfang und am Ende der nebeneinander angeordneten elektronischen Schaltungen ein einfaches Abschirmblech ausreicht, welches auf einer Seite planparallel zu der elektronischen Schaltung angeordnet ist, da hier in einem solchen Fall von dem Gehäuse aus Metall des Hochfrequenzgerätes die weitere Abschirmung erfolgt.

Ausführungsbeispiele einer erfindungsgemäßen Abschirmung sind im folgenden erläutert und anhand der Figuren beschrieben.

Es zeigen:
- Figur 1: eine elektronische Schaltung mit einem einfachen Abschirmblech,
- Figur 2: Klemmittel des Abschirmbleches,
- Figur 3: Ausführung eines Abschirmbleches, welches eine elektronische Schaltung nahezu vollständig umgibt.

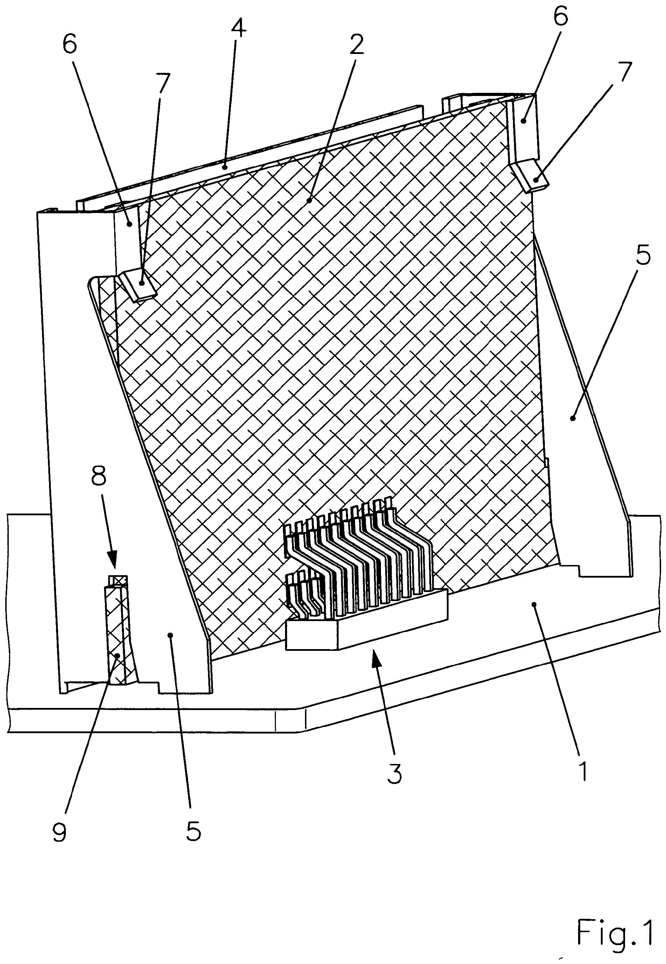

Figur 1 zeigt eine Bodenplatte 1, die Bestandteil eines nicht weiter dargestellten Gehäuses eines Hochfrequenzgerätes ist. In etwa senkrecht zu der Bodenplatte 1 ist eine elektronische Schaltung 2 (Modul) angeordnet, deren Kontaktierung über eine Steckverbindung 3 mit weiteren elektronischen Schaltungen, einem Eingang, einem Ausgang oder dergleichen des Hochfrequenzgerätes erfolgt. In etwa planparallel zu der elektrischen Schaltung 2 ist ein Abschirmblech 4 vorgesehen, wobei das in Figur 1 gezeigte Abschirmblech 4 ein Stanzbiegeteil ist. Die Herstellung des Abschirmbleches 4 im Stanzbiegeverfahren aus einem Blech hat den Vorteil, daß die im folgenden beschriebenen Elemente des Abschirmbleches 4 mittels des Stanzbiegeverfahrens einfach und kostengünstig hergestellt werden können. Um das Abschirmblech 4 auf der Bodenplatte 1 anordnen zu können, ist parallel zu den Seitenrändern der elektronischen Schaltung 2 eine Abwinklung 5 vorgesehen, die hier in etwa dreieckförmig verläuft. Damit kann sich die umlaufende Unterkante des Abschirmbleches 4 sehr gut auf der Bodenplatte 1 abstützen. Am oberen Ende des Abschirmbleches 4 sind Laschen 6 vorhanden, die gegebenenfalls einen abgewinkelten Vorsprung 7 aufweisen können. An diesen Laschen 6, die Bestandteil der Klemmittel zur Lagefixierung der elektronischen Schaltung 2 sind, kommt die Leiterplatte der elektronischen Schaltung 2 zur Anlage, so daß die elektronische Schaltung 2 mittels des Abschirmbleches 4 in ihrer in Figur 1 gezeigten senkrechten Lage auf der Bodenplatte 1 fixiert werden kann. Zur weiteren Lagefixierung der elektronischen Schaltung 2 ist in dem Bereich der Abwinklung 5 eine schlitzartige Ausnehmung 8 vorhanden, in die ein Vorsprung 9 der Leiterplatte der elektronischen Schaltung 2 eingreifen kann. Damit wird, nachdem das Abschirmblech 4 auf der Bodenplatte 1 befestigt wurde, die elektronische Schaltung 2 zusätzlich in ihrer Lage fixiert, so daß eine Bewegung relativ zu der Bodenplatte 1 verhindert wird. Dies ist gerade im Hinblick auf die Kontaktierung über die Steckverbindung 3 wichtig, damit es hier nicht zu einer Unterbrechung kommt. Wie in Figur 1 dargestellt, umgibt das Abschirmblech 4 die elektronische Schaltung 2 nahezu vollständig auf der einen Seite und zumindest teilweise am Rand, während die andere Seite der elektronischen Schaltung 2 bleibt. Für diesen Bereich kann z. B. eine aus Metall bestehende Seitenwand des Gehäuses, das über die Bodenplatte 1 gestülpt wird, die Abschirmung vornehmen.

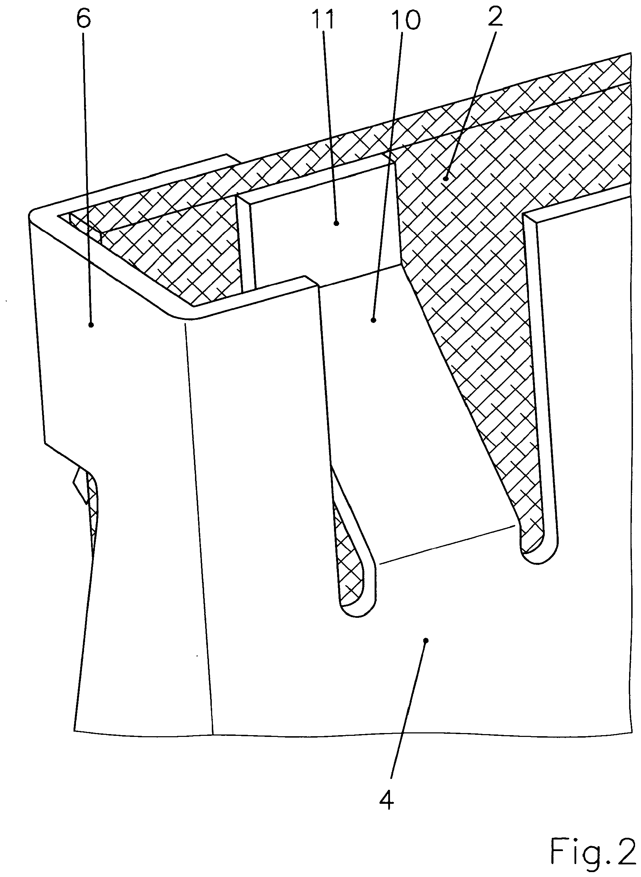

Figur 2 zeigt weitere Bestandteile der Klemmittel, mittels derer die elektronische Schaltung 2 an dem Abschirmblech 4 unter Krafteinwirkung gehalten wird. Neben den Bestandteilen der Lasche 6 und dem abgewinkelten Vorsprung 7 sind als Klemmittel eine weitere Lasche 10, die gegebenenfalls ebenfalls eine Abwinklung 11 aufweist, vorhanden. Dabei ist die Lasche 6 so gestaltet, daß die Leiterplatte der elektronischen Schaltung 2 an ihr zur Anlage kommt, während die Lasche 10 (bzw. deren Abwinklung 11) die Leiterplatte der elektronischen Schaltung 2 gegen die Lasche 6 drückt. Durch diese Ausgestaltung der Klemmittel wird einerseits gewährleistet, daß die Leiterplatte der elektronischen Schaltung 2 ausreichend fest an dem Abschirmblech 4 zur Anlage kommt. Gleichzeitig ist ein Toleranzausgleich durch die Klemmittel gegeben, wobei zusätzlich noch der Vorteil eines Spielausgleiches gegeben ist, wenn sich die Leiterplatte 2 bzw. das Abschirmblech 4 in Folge von Temperaturveränderungen ausdehnt bzw. zusammenzieht. Die Gestaltung des abgewinkelten Vorsprungs 7 hat den Vorteil, daß die Leiterplatte der elektronischen Schaltung 2 auch dann in das Abschirmblech 4 eingesetzt werden kann, wenn dieses schon auf der Bodenplatte 1 montiert wurde. Durch diesen Vorsprung 7 ist also eine Führung der Leiterplatte beim Einsetzen gegeben. Die Ausgestaltung der Lasche 10 bzw. der Abwinklung 11 hat den Vorteil, daß sie den Einsetzvorgang der Leiterplatte des Abschirmblechs 4 führen und, nachdem die Leiterplatte eingesetzt worden ist, inbesondere die Abwinklung 11 die Leiterplatte gegen die Lasche 6 drückt, so daß die Leiterplatte der elektronischen Schaltung 2 äquidistant zu dem gesamten Abschirmblech 4 in ihrer Lage fixiert ist. Dadurch wird einerseits der gewünschte Abschirmeffekt erzielt, während andererseits ein Raum zwischen der elektronischen Schaltung 2 und dem Abschirmblech 4 entsteht, durch den Kühlluft zwecks Kühlung der elektronischen Schaltung geführt werden kann.

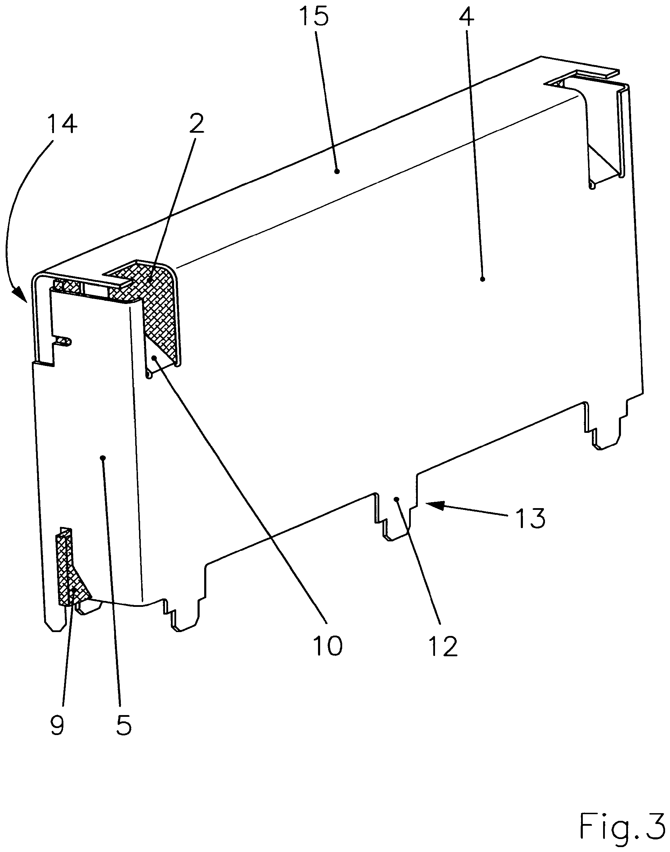

Figur 3 zeigt ein Abschirmblech 4, welches ebenfalls - wie die in Figur 1 und 2 gezeigten Abschirmbleche - ein Stanzbiegeteil ist und deren Elemente, insbesondere die Klemmittel zur Lagefixierung der Leiterplatte, aufweist. Das in Figur 1 gezeigte Abschirmblech ist dabei so geformt, daß es die elektronische Schaltung 2 nahezu vollständig umgibt. Dies ist gerade dann erforderlich, wenn in dem Hochfrequenzgerät mehrere elektronische Schaltungen planparallel zueinander bzw. nebeneinander angeordnet sind, um gegenseitige Störstrahlungen zu vermeiden. Das in Figur 3 gezeigte Abschirmblech 4 weist genauso wie die in den vorangegangenen Figuren gezeigten Abschirmbleche Füße 12 auf, die derart gestaltet sind, daß das Abschirmblech 4 zumindest teilweise auf Distanz zu der Bodenplatte 1 des Hochfrequenzgerätes angeordnet ist. Zu diesem Zweck weisen die Füße 12 einen Absatz 13 auf, so daß mit dem schmaleren Bereich der Fuß 12 in einem korrespondieren Schlitz in der Bodenplatte 1 eingeführt und dort befestigt werden kann. Der Absatz 13 gewährleistet dann die Lagefixierung des Abschirmbleches 4 auf Distanz zu der Bodenplatte 1, so daß zwischen den einzelnen Füßen 12 Schlitze bzw. Fenster verbleiben, durch welche Kühlluft strömen kann. Das in Figur 3 gezeigte Abschirmblech 4 ist also als Stanzbiegeteil so geformt, daß es die elektronische Schaltung nahezu vollständig umgibt (abschirmt), wobei die in Figur 3 mit der Bezugsziffer 4 vorgesehene Seite des Abschirmbleches 4 um eine Rückseite 14 und eine Oberseite 15 ergänzt ist, wobei bei dieser Ausführungsform die Abwinklungen 5 nicht dreieckförmig, sondern in etwa rechteckförmig ausgestaltet sind, um die Seiten zu schließen.

Eine besonders bevorzugte Anwendung der erfindungsgemäßen Abschirmung ist im Bereich von Fahrzeugen gegeben, bei denen die Integrationsdichte von Hochfrequenzgeräten, die in Frequenzbereichen deutlich oberhalb von 100 Megahertz arbeiten, weiter zunimmt. Hier spielt die Einstrahlung bzw. Abgabe von Störstrahlungen eine große Rolle, so daß solche Störstrahlungen unbedingt vermieden werden müssen. Mit der hohen Packungsdichte bzw. Integrationsdichte einher gehen Probleme der Kühlung, so daß gerade bei der Anwendung von Hochfrequenzgeräten in Fahrzeugen, wie beispielweise Antennenverstärker, TV-Tuner und dergleichen, die erfindungsgemäße Abschirmung von besonderem Vorteil ist, da sie zum einen die erforderliche Abschirmung gewährleistet und gleichzeitig eine ausreichende Kühlung von elektronischen Schaltungen innerhalb eines Gehäuses des Hochfrequenzgerätes sicherstellt.

### Bezugszeichenliste

1. Bodenplatte
2. Elektronische Schaltung
3. Steckverbindung
4. Abschirmblech
5. Abwinklung
6. Laschen
7. Abgewinkelter Vorsprung
8. Ausnehmung
9. Vorsprung
10. Lasche
11. Abwinklung
12. Fuß
13. Absatz
14. Rückseite
15. Oberseite

## Patentansprüche

1. Abschirmung für eine elektronische Schaltung (2) eines Hochfrequenzgerätes, insbesondere eines TV-Tuners, eines Fahrzeuges, mit einem Abschirmblech (4), wobei das Abschirmblech (4) zumindest planparallel zu der elektronischen Schaltung (2) angeordnet ist und die Befestigung der elektronischen Schaltung (2) In dem Hochfrequenzgerät über das Abschirmblech (4) erfolgt, wobei das Abschirmblech (4) Füße (12) aufweist, **dadurch gekennzeichnet dass** die Füße (12) derart gestaltet sind, dass das Abschirmblech (4) zumindest teilweise auf Distanz zu der Bodenplatte (1) des Hochfrequenzgerätes angeordnet ist, sowie Klemmmittel zur Halterung der elektronischen Schaltung (2) aufweist, wobei die Klemmmittel als eine federnde Lasche (10) mit einer Abwinklung (11) ausgebildet sind.

## Claims

1. Shield for an electronic circuit (2) of a high-frequency device, in particular a TV tuner, of a vehicle, comprising a shielding plate (4), the shielding plate (4) being arranged at least plane-parallel to the electronic circuit (2) and the electronic circuit (2) being fastened in the high-frequency device by means of the shielding plate (4), the shielding plate (4) having feet (12), **characterized in that** the feet (12) are designed in such a way that the shielding plate (4) is at least partially arranged at a distance from the baseplate (1) of the high-frequency device, and also has clamping means for holding the electronic circuit (2), the clamping means being formed as a resilient lug (10) with an angled piece (11) .

## Revendications

1. Blindage pour un circuit électronique (2) d'un appareil à haute fréquence, en particulier d'un syntoniseur TV, d'un véhicule, comportant une plaque de blindage (4), dans lequel la plaque de blindage (4) est disposée au moins de manière plan-parallèle au circuit électronique (2) et la fixation du circuit électronique (2) dans l'appareil à haute fréquence est réalisée au-dessus de la plaque de blindage (4), dans lequel la plaque de blindage (4) comporte des pieds (12), **caractérisé en ce que** les pieds (12) sont conçus de telle manière que la plaque de blindage (4) est disposée au moins partiellement à distance de la plaque de base (1) de l'appareil à haute fréquence et comporte des moyens de serrage destinés à maintenir le circuit électronique (2), dans lequel les moyens de serrage sont réalisés sous la forme d'une patte élastique (10) présentant un coude (11) .
